# EUROPEAN PATENT APPLICATION

(11) **EP 2 393 121 A1**
(43) Date of publication of application: **07.12.2011**
(21) Application number: 10735790.7
(22) Date of filing: 26.01.2010
(51) Int. Cl.: H01L 31/04

(54) **SOLAR CELL MODULE AND METHOD OF PRODUCING SAME**

(30) Priority: 30.01.2009 JP 2009020314
(71) Applicant: Sharp Kabushiki Kaisha, Osaka-shi, Osaka 545-8522 (JP)
(72) Inventor: SUZUKI, Yuji, Osaka 545-8522 (JP)
(74) Representative: Müller - Hoffmann & Partner
(86) International application number: PCT/JP2010/050945
(87) International publication number: WO 2010/087322

(57) **Abstract**

In a solar cell module and a manufacturing method thereof according to an embodiment of the present invention, the solar cell module has a configuration in which in a solar cell element (10) including a transparent conductive film (12), a photoelectric conversion layer (13) and a back face electrode layer (14) formed on a light-transmitting insulating substrate (11), a bus bar (21) is bonded on the back face electrode layer (14) with a conductive adhesive (18), and the bus bar (21) has a portion in which a plurality of conductive wires (21a, 21a, ...) are disposed side by side in a direction perpendicular to a longitudinal direction of the transparent conductive film (12) or the back face electrode layer (14). These conductive wires (21a, 21a, ...) are disposed to be spaced apart from each other in the direction perpendicular to the longitudinal direction of the transparent conductive film (12) or the back face electrode layer (14).

## Description

### Technical Field

The present invention relates to a solar cell module having excellent adhesion with which a bus bar is bonded to a back face electrode layer of a solar cell element, and a manufacturing method thereof.

### Background Art

Conventionally, as a thin film solar cell, an integrated thin film solar cell has been proposed in which a solar cell string is formed by connecting laminates (solar cells) in series, parallel or series-parallel. In each solar cell, a transparent conductive film made of ZnO, ITO, SnCl₂ or the like is formed on a light-transmitting insulating substrate made of glass or the like. On that film, a photoelectric conversion layer is formed including a p-layer, an i-layer and an n-layer stacked in sequence made of a thin film semiconductor such as amorphous silicon. Furthermore, a back face electrode layer made of, for example, ZnO and Ag is formed thereon (see, for example, Patent Document 1). With the integrated thin film solar cell disclosed in Patent Document 1, it is proposed to bond a tape-shaped bus bar made of a copper foil or the like onto a back face electrode layer via a conductive paste and use the bus bar as a power extraction electrode portion in the thin film solar cell.

The process of bonding the bus bar includes the steps of applying the conductive paste on the back face electrode layer, drawing the tape-shaped bus bar wound on a reel (bobbin) along the back face electrode layer and disposing the bus bar onto the applied conductive paste, and bonding the bus bar onto the back face electrode layer via the conductive paste by application of heat while applying pressure from above the drawn bus bar.

### Prior Art Document

### Patent Document

Patent Document 1: JP 2002-314104 A

### Summary of Invention

### Problems to be Solved by the Invention

As described above, the conventional bus bar used as a power extraction electrode portion in a thin film solar cell has a tape shape. In other words, because the conventional bus bar has a two dimensional plane, the bus bar, when drawn from the reel or the like, meanders and undulates and thus does not extend straight like a thread. Accordingly, in the conventional bonding step, the bus bar drawn from the reel or the like is temporarily drawn with application of tension so as to straighten the bus bar, and the straightened bus bar is bonded onto the back face electrode layer. In the case of a unit solar cell with each side measuring 20 cm, for example, a bus bar having a length of about 20 cm is straightened by stretching it about 3 to 5 mm.

However, even if tension is applied to slightly stretch the bus bar as described above, it is not possible to perfectly straighten the bus bar, and thus slight meanders and undulations remain as distortions. For this reason, in the conventional technology, the amount of such distortions in the bus bar is taken into account, and some leeway is given to the width of the electrode portion of the back face electrode layer. Specifically, when the bus bar has a width of 2 mm, the width of the electrode portion of the back face electrode layer is 4 to 5 mm.

In terms of the conversion efficiency of the solar cell, it is preferable to form solar cells on the entire light transmitting insulating substrate and minimize the amount of area to which the bus bar serving as an electrode portion is bonded, but as described above, the bus bar has distortions, and therefore the power extraction electrode portion of the back face electrode layer need to have a correspondingly increased width. For this reason, the conventional solar module is problematic in that the energy conversion efficiency indicated by numerical values is reduced by an amount corresponding to the increased width.

Also, in the case where the tape-shaped bus bar is used, the bond area is limited to a plane, and therefore there is a problem in that when stress is applied, the bonded face is easily damaged.

The present invention has been conceived to solve the problems described above, and it is an object of the present invention to provide a solar cell module in which the energy conversion efficiency thereof is improved and the bonding strength of the bus bar is improved by devising the shape of the bus bar, and a manufacturing method thereof.

### Means for Solving the Problems

In order to solve the problems described above, a solar cell module according to the present invention is a solar cell module having a configuration in which in a solar cell element including a first electrode layer, a photoelectric conversion layer and a second electrode layer formed on a substrate, a bus bar is bonded on the first electrode layer or the second electrode layer with a conductive adhesive material, wherein the bus bar has a portion in which a plurality of conductive wires are disposed side by side in a direction perpendicular to a longitudinal direction of the first electrode layer or the second electrode layer.

In the present invention, the bus bar is formed using a plurality of conductive wires. The conductive wires generally have a cross-sectional shape of a circle, ellipse or the like. However, the cross-sectional shape may be polygonal or the like as long as wires are used. With the bus bar formed using conductive wires as described above, by simply drawing the conductive wires from reels or the like while applying tension, meandering and undulation of the conductive wires can be straightened and the conductive wires can be linearly drawn. Accordingly, unlike the case of the conventional tape-shaped bus bar, it is unnecessary to apply tension until the conductive wires are stretched to some extent. Because linearity can be obtained by simply applying tension in the manner described above, the conductive wires can be disposed precisely on the first electrode layer or the second electrode layer. For this reason, it is unnecessary to give leeway to the electrode width on the first electrode layer or the second electrode layer, and therefore the width can be reduced to a minimum, and the area where solar cells are formed can be increased by an amount corresponding to the reduced width, as a result of which the energy conversion efficiency can be improved accordingly.

In this case, it is preferable that the conductive wires are disposed to be spaced apart from each other in the direction perpendicular to the longitudinal direction of the first electrode layer or the second electrode layer. By disposing the conductive wires to be spaced apart from each other as described above, when the conductive wires are pressed against and bonded to the first electrode layer or the second electrode layer via the conductive adhesive material, the conductive adhesive material fills the gaps between adjacent conductive wires, whereby the bond area can be increased and therefore the bonding strength can be improved. In the conventional tape-shaped bus bar, the bond area is limited to a plane, and therefore the bonded face is easily damaged when stress is applied, but in the present invention, the conductive adhesive material is bonded to have an arc-shaped cross section and surround the conductive wires, and thus a bonding structure less subject to damage even when stress is applied can be obtained.

A manufacturing method of a solar cell module according to the present invention is a manufacturing method of a solar cell module including the steps of: in a solar cell element including a first electrode layer, a photoelectric conversion layer and a second electrode layer formed on a substrate, disposing a bus bar on the first electrode layer or the second electrode layer; and bonding the bus bar to the first electrode layer or the second electrode layer with a conductive adhesive material, wherein the bus bar is formed with a plurality of conductive wires disposed side by side in a direction perpendicular to a longitudinal direction of the first electrode layer or the second electrode layer, and the disposing step includes a step of drawing, with application of tension, the plurality of conductive wires wound on reels along the longitudinal direction of the first electrode layer or the second electrode layer at specified intervals, so as to dispose the plurality of conductive wires side by side in the direction perpendicular to the longitudinal direction.

According to the manufacturing method of the present invention, for example, in the case where five conductive wires are used, five reels each having a conductive wire wound thereon are provided at one end of the first electrode layer or the second electrode layer, and by drawing the conductive wires from the reels at the same tension along the longitudinal direction of the first electrode layer or the second electrode layer, the conductive wires can be straightened and drawn. Accordingly, in this state, by application of heat while the five drawn conductive wires are pressed against the conductive adhesive material that has been applied on the first electrode layer or the second electrode layer, the conductive wires are pressed into the conductive adhesive material so as to cut (displace) the conductive adhesive material, and are lowered to the first electrode layer or the second electrode layer, whereby the conductive wires can be bonded to the first electrode layer or the second electrode layer.

A manufacturing method of a solar cell module according to the present invention is a manufacturing method of a solar cell module including the steps of: in a solar cell element including a first electrode layer, a photoelectric conversion layer and a second electrode layer formed on a substrate, disposing a bus bar on the first electrode layer or the second electrode layer; and bonding the bus bar to the first electrode layer or the second electrode layer with a conductive adhesive material, wherein the bus bar is formed with a plurality of conductive wires disposed side by side in a direction perpendicular to a longitudinal direction of the first electrode layer or the second electrode layer, and the disposing step includes a step of sequentially repeating operations of drawing, with application of tension, a single conductive wire wound on a reel from one end of the back face electrode layer in one direction along the longitudinal direction to another end of the back face electrode layer, then folding back the conductive wire at the other end and drawing the conductive wire in another direction along the longitudinal direction to the one end of the back face electrode layer, and again folding back the conductive wire at the one end and drawing the conductive wire in the one direction along the longitudinal direction, so as to dispose the plurality of conductive wires side by side in the direction perpendicular to the longitudinal direction.

The manufacturing method of the present invention employs a configuration in which a single conductive wire wound on a single reel is continuously drawn in a zigzag pattern by folding back the conductive wire a required number of times, and thereby apparently a plurality of conductive wires are disposed on the first electrode layer or the second electrode layer. In other words, by drawing a single conductive wire in a repeated pattern, a plurality of conductive wires that are to be disposed on the first electrode layer or the second electrode layer can be pulled at a uniform tension, and therefore the conductive wires can be straightened and drawn more uniformly. Also, because only a single reel is used, the mechanism for drawing the conductive wire can be simplified and made compact, and the manufacturing cost can be reduced correspondingly.

Then, in this state, by application of heat while the single conductive wire drawn in a repeated pattern is pressed against the conductive adhesive material that has been applied on the first electrode layer or the second electrode layer, the conductive wire is pressed into the conductive adhesive material so as to cut (displace) the conductive adhesive material, and is lowered to the first electrode layer or the second electrode layer, whereby the conductive wire can be bonded to the first electrode layer or the second electrode layer.

### Brief Description of Drawings

[FIGS. 1] FIG. 1(a) is a cross-sectional view showing an example of a configuration of a solar cell module according to the present invention, and FIG. 1(b) is a partially enlarged cross-sectional view of the same.
[FIGS. 2] FIGS. 2 are illustrative diagrams showing thin film solar cell manufacturing steps according to a manufacturing method of the present invention.
[FIG. 3] FIG. 3 is a perspective view showing an example of arrangement of a conductive adhesive according to the manufacturing method of the present invention..
[FIGS. 4] FIGS. 4 are illustrative diagrams showing a method of disposing conductive wires that constitute a bus bar according to Example 1.
[FIG. 5] FIG. 5 is an illustrative diagram showing a wiring step according to the manufacturing method of the present invention.
[FIG. 6] FIG. 6 is an illustrative diagram showing a laminating step according to the manufacturing method of the present invention.
[FIGS. 7] FIGS. 7 are illustrative diagrams showing a method of disposing conductive wires that constitute a bus bar according to Example 2.

### Modes for Carrying out the Invention

Hereinafter, embodiments of the present invention will be described with reference to the drawings.

### Description of solar cell module manufactured by manufacturing method of the present invention

A solar cell module manufactured by a manufacturing method according to the present invention will be described taking a thin film solar cell as an example.

A thin film solar cell according to the present embodiment includes at least a light-transmitting insulating substrate, a transparent conductive film (corresponding to the first electrode layer recited in the claims) provided on the light-transmitting insulating substrate, a photoelectric conversion layer and a back face electrode layer (corresponding to the second electrode layer recited in the claims), and a bus bar provided on the back face electrode layer. The bus bar is electrically connected to the back face electrode layer by a conductive adhesive material, and thus the back face electrode layer is used as an extraction electrode. The bus bar may be connected to the transparent conductive film (corresponding to the first electrode layer recited in the claims). In the case where the bus bar is connected to the transparent conductive film, the photoelectric conversion layer and the back face electrode layer are removed by using, for example, the second harmonic of a YAG laser or a laser such as a YVO₄ laser so as to expose the transparent conductive film, and the bus bar is electrically connected to the exposed portion with a conductive adhesive material. In this manner, by connecting the bus bar to the transparent conductive film, it is also possible to use the transparent conductive film as an extraction electrode.

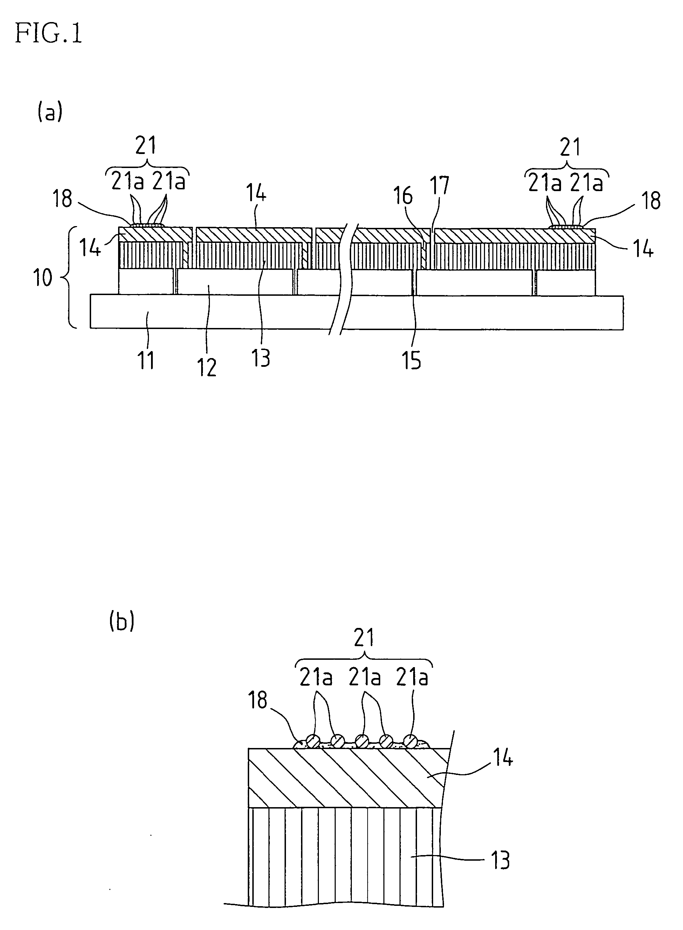

FIG. 1(a) is a cross-sectional view showing an example of a configuration of the thin film solar cell according to the present embodiment, and FIG. 1(b) is a partially enlarged cross-sectional view of the same.

The thin film solar cell shown in FIGS. 1 has the following configuration. A laminate (solar cell) including a transparent conductive film 12, a photoelectric conversion layer 13 and a back face electrode layer 14 is formed on a light-transmitting insulating substrate 11, and such laminates are connected in series, parallel or series-parallel to form a solar cell string 10. A bus bar 21 is electrically connected to the back face electrode layer 14 by a conductive adhesive material (a conductive adhesive in the present embodiment) 18.

As the light-transmitting insulating substrate 11, a glass substrate or the like can be used. As the transparent conductive film 12, for example, a conductive oxide capable of transmitting light such as ZnO, ITO or SnCl₂ can be used. The photoelectric conversion layer 13 can have a structure in which, a p-layer, an i-layer and an n-layer, each made of, for example, a semiconductor thin film, are stacked in sequence. Also, as the semiconductor thin film, for example, an amorphous silicon thin film, a crystalline silicon thin film, or a combination thereof can be used.

The back face electrode layer 14 can be composed of, for example, a layer made of a conductive oxide such as ZnO and a layer made of a metal such as silver or a silver alloy. An example of more ordinary back face electrode layer can be a ZnO/Ag double layer.

The conductive adhesive 18 preferably contain a thermosetting resin and conductive particles. Examples of preferred thermosetting resins include resins having a curing temperature ranging from 150 to 250°C. When the thermosetting resin has a curing temperature of 150°C or greater, the conductive adhesive portion has a large physical strength, and thus a thin film solar cell having particularly good reliability can be obtained. When the thermosetting resin has a curing temperature of 250°C or less, the conductive adhesive 18 will not easily separate from the back face electrode layer 14 or the bus bar 21, and thus a solar cell module having particularly good reliability can be obtained. Examples of more preferred thermosetting resins include resins that cure in approximately several seconds at a curing temperature ranging from 150 to 250°C. Specific examples of preferred thermosetting resins include resins containing an epoxy resin, acrylic resin or the like as a main component. Examples of preferred conductive particles include nickel particles, nickel particles plated with gold or the like, resin particles, and the like. The conductive particles preferably have an average particle size ranging from, for example, 3 to 10 µm.

It is also possible to use conductive tape as the conductive adhesive 18. In this case, the conductive tape is preferably an anisotropically conductive tape. As used herein, the anisotropically conductive tape means an electrically anisotropic tape that provides conductivity in the thickness direction and insulation in the surface direction of the press-bonded portion. When the anisotropically conductive tape is used, particularly good effects of providing good adhesion to the back face electrode layer and the bus bar can be obtained irrespective of the type of the metal film of the back face electrode layer. Other than the conductive adhesive or conductive tape described in the present embodiment, it is also possible to use solder, a conductive paste or the like as the conductive adhesive material of the present invention.

The conductive adhesive 18 is preferably applied to a plurality of locations at specified intervals along the longitudinal direction on the surface of the back face electrode layer 14 where the bus bar is to be formed.

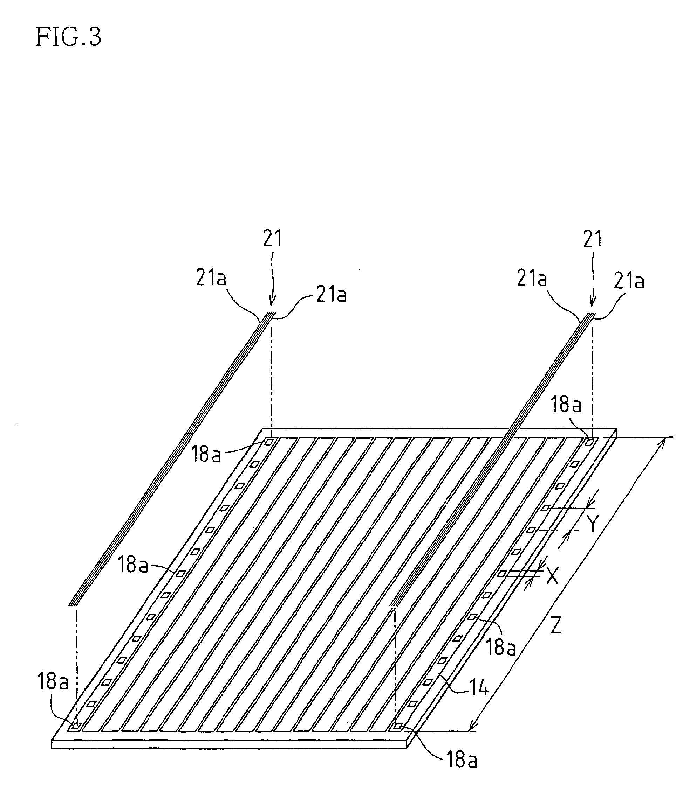

As shown in FIGS. 1(b) and 3, the bus bar 21 is formed by a plurality of conductive wires 21a, and the wires generally have a cross-sectional shape of, for example, a circular shape, an elliptic shape, or the like. By forming the bus bar 21 using a plurality of conductive wires 21a in this manner, when the conductive wires 21a are drawn from reels or the like, which will be described later, the conductive wires 21a can be straightened and drawn by simply applying tension to the conductive wires 21a. Accordingly, a plurality of conductive wires 21a can be disposed precisely on the back face electrode layer 14.

In the present embodiment, five conductive wires 21a are disposed in parallel in a direction perpendicular to the longitudinal direction of the back face electrode layer 14. In this case, the conductive wires 21a are preferably disposed such that there is a small space between adjacent conductive wires 21a. By disposing the conductive wires 21a to be spaced apart from each other as described above, when the conductive wire 21a are pressed against and bonded to the back face electrode layer 14 via the conductive adhesive 18, the conductive adhesive fills the gaps between adjacent conductive wires 21a, whereby the bond area can be increased and therefore the bonding strength can be improved.

It is preferable that the conductive wires 21a having a circular cross-sectional shape have a thickness (diameter) of approximately 60 to 120 µm. In the present embodiment, the electrode portion of the back face electrode layer 14, which is the portion where the bus bar is to be formed, has a width of about 2 mm.

As the material of the conductive wires 21a, for example, a material having a low electric resistance is preferably used such as copper, silver, gold, platinum, aluminum, molybdenum, tungsten, or an alloy of any of these. A thin metal layer may be formed on the surface of the conductive wires 21a, for the purpose of improving adhesion and electrical conductivity, preventing corrosion and oxidation, and the like. As the metal layer formed on the surface, it is preferable to use a noble metal, which is less prone to corrosion, such as silver, palladium, an alloy of silver and palladium, or gold, or a metal having excellent corrosion resistance such as nickel or tin.

### Description of manufacturing method of thin film solar cell according to the present invention

### [Example 1]

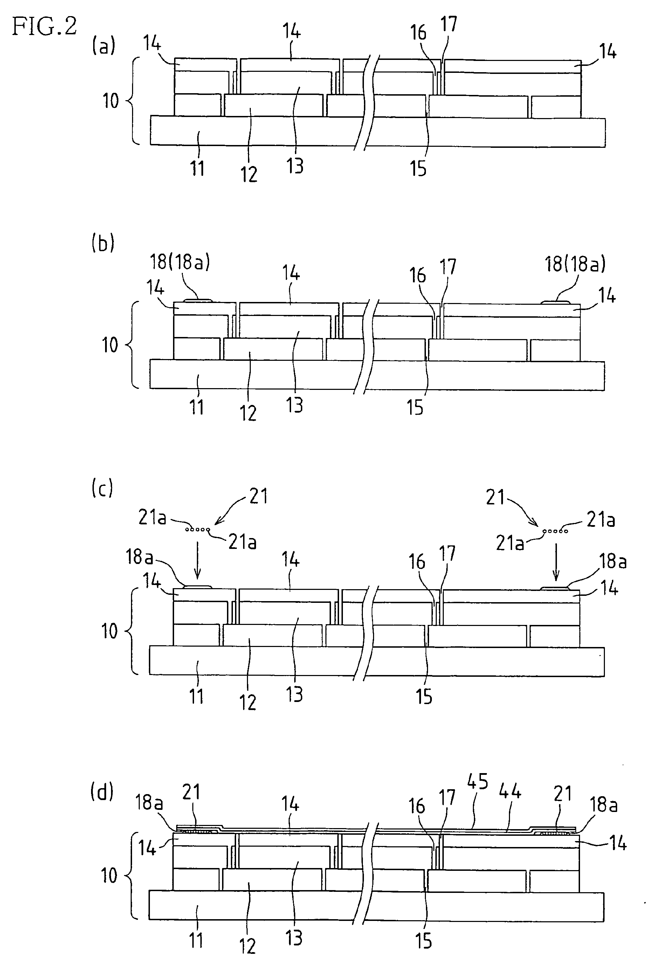

Next, a method of manufacturing a thin film solar cell having the above-described configuration according to Example 1 will be described in several steps including a solar cell string forming step, an adhesive application step, a bus bar disposing step, a bonding step, and a wiring and laminating step, with reference to FIGS. 2 to 6.

### (1) Solar cell string forming step (see FIG. 2(a))

First, a transparent conductive film 12 is formed on a light-transmitting insulating substrate 11 such as a glass substrate, using, for example, SnO₂ (tin oxide) by a thermal CVD method or the like. Next, patterning is performed on the transparent conductive film 12 using the fundamental wave of a YAG laser or the like. Next, laser light is caused to be incident upon the surface of the glass substrate to split the transparent conductive film 12 into strips, forming split lines 15, after which the glass substrate is ultrasonically cleaned in pure water to form a photoelectric conversion layer 13. As the photoelectric conversion layer 13, for example, a film including an upper (light-receiving face-side) cell composed of an a-Si:H p-layer and an a-Si:H i-layer and a lower cell composed of a µc-Si:H p-layer and a µc-Si:H n-layer is formed.

Next, patterning is performed on the photoelectric conversion layer 13 by using, for example, the second harmonic of a YAG laser or a YVO₄ laser. Laser light is caused to be incident upon the surface of the glass substrate to split the photoelectric conversion layer 13 into strips, forming contact lines 16 for electrically connecting the transparent conductive film 12 and a back face electrode layer 14.

Next, a ZnO (zinc oxide)/Ag film is formed as the back face electrode layer 14 by a magnetron sputtering method or the like. The thickness of the ZnO film can be approximately 50 nm. Instead of the ZnO film, a film having high light-transmitting properties may be used such as ITO or SnO_{2.} The thickness of the silver film can be approximately 125 nm. In the back face electrode layer 14, the transparent conductive film such as ZnO may be omitted, but it is desirable to have the transparent conductive film in order to obtain a high conversion efficiency.

Next, patterning is performed on the back face electrode layer 14 using a laser. Laser light is caused to be incident upon the surface of the glass substrate to split the back face electrode layer 14 into strips, forming split lines 17. At this time, in order to avoid damage by the laser to the transparent conductive film 12, as the laser, it is preferable to use the second harmonic of a YAG laser or the like having good penetrability to the transparent conductive film 12. It is also possible to use a YVO₄ laser. Also, it is preferable to select processing conditions that minimize damage to the transparent conductive film 12 and suppress the occurrence of burrs in the processed silver electrode of the back face electrode layer 14.

A solar cell string 10 as shown in FIG. 2(a) is formed in the manner described above.

### (2) Application step (see FIGS. 2(b) and 3)

In the application step, a conductive adhesive 18 is applied at specified intervals on the back face electrode layer 14 of the solar cell string 10 having the configuration described above.

To describe it specifically, the conductive adhesive 18 (18a, 18a, ...) is applied to a plurality of locations at specified intervals on the surface of the back face electrode layer 14 where a bus bar is to be formed. In other words, as shown in FIG. 3, conductive adhesives 18a, each having an applied length X, are applied onto the back face electrode layer 14 at a pitch Y. In this case, the applied length X of the conductive adhesive 18a can be, for example, approximately 3 to 10 mm, and the pitch Y can be, for example, approximately 70 to 100 mm. The applied thickness is approximately 30 µm. A length Z of the back face electrode layer 14 where a bus bar is to be formed is approximately 1400 mm, and therefore the conductive adhesive 18a is applied to 14 to 20 locations on a single back face electrode layer 14. In the example shown in FIG. 3, the conductive adhesive 18a is applied to 28 locations in total on two back face electrode layers: the back face electrode layer 14 on the left side and the back face electrode layer 14 on the right side. In some cases, a bus bar may be bonded to the back face electrode layer located at the center. In this case, the conductive adhesive 18a is applied to 42 locations in total.

### (3) Bus bar disposing step (see FIG. 2(c))

In the bus bar disposing step, a plurality of conductive wires wound around reels are drawn at specified intervals with application of tension along the longitudinal direction of the back face electrode layer.

Specifically, on each back face electrode layer 14 that has the conductive adhesives 18a applied thereto, five conductive wires 21a are disposed side by side in the direction perpendicular to the longitudinal direction of the back face electrode layer 14.

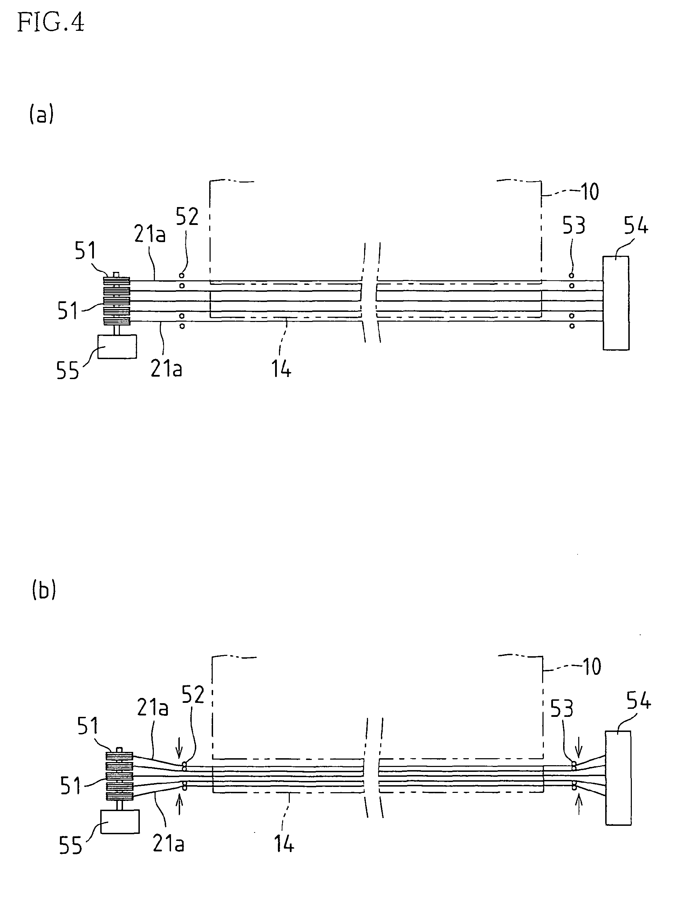

As a method of disposing five conductive wires 21a side by side, for example, as shown in FIGS. 4, five reels 51, each with a conductive wire 21a wound thereon, are provided at one end (the left end in FIGS. 4) of the back face electrode layer 14 of the solar cell string 10 placed on a stage (not shown), and the conductive wires 21a are drawn with application of tension from the reels 51 to the other end (the right end in FIGS. 4) of the back face electrode layer 14. Thereafter, the conductive wires 21a are regulated to extend in a specified direction and to have intervals by four drawing direction regulating pins (or regulating rollers) 52 and 53 provided respectively at the left and right ends of the back face electrode layer 14, whereby five conductive wires 21a can be disposed side by side in the direction perpendicular to the longitudinal direction of the back face electrode layer 14.

As a method of drawing the conductive wires 21a, the tips of the conductive wires 21a pulled from the reels 51 are held by a chuck member 54 and the chuck member 54 is provided so as to be reciprocally moved by a driving means (not shown) between one end of the back face electrode layer 14 and the other end.

To apply tension to the conductive wires 21a when they are drawn, a configuration may be used in which a dispensing mechanism 55 is provided to the reels 51 and a uniform tension is constantly applied to the drawn conductive wires 21a by the dispensing mechanism 55.

The drawing direction regulating pins 52 and 53 respectively provided at the left and right ends of the back face electrode layer 14 are configured to be capable of vertical movement, as well as horizontal movement in the direction perpendicular to the longitudinal direction of the back face electrode layer 14. Specifically, when the conductive wires 21a are drawn by the chuck member 54, the drawing direction regulating pins 52 and 53 are laid out so as to extend in the horizontal direction to match the width of the conductive wires 21a drawn from the rollers 51, and kept lowered (see FIG. 4(a)). Then, when the conductive wires 21a have been drawn to the other end of the back face electrode layer 14 by the chuck member 54, the drawing direction regulating pins 52 and 53 are raised such that they are inserted between the conductive wires 21a (see FIG. 4(a)). In this state, the drawing direction regulating pins 52 and 53 are horizontally moved toward the center in the width direction to achieve specified intervals (the direction of movement being indicated by arrows in FIG. 4(b)), whereby five conductive wires 21a can be disposed side by side at specified intervals on the back face electrode layer 14 as shown in FIG. 4(b).

In the above description, drawing of the conductive wires 21a is performed on the back face electrode layer 14, but it may be possible to, after the conductive wires 21a have been drawn, move the solar cell string 10 such that the back face electrode layer 14 is positioned under the conductive wires 21a. Also, FIGS. 4 illustrate an example in which the tips of five conductive wires 21a are held by a single chuck member 54, but it is also possible to provide five chuck members 54 so as to correspond to the reels 51. Furthermore, in FIGS. 4, the distance in which tension is applied to the conductive wires 21a by the drawing direction regulating pins 52 and 53 extends from the right outer end to the left outer end of the solar cell string 10, but the distance in which tension is applied may extend within a range of the lengthwise direction of the back face electrode layer 14. Waste of material during cutting can thereby be minimized.

### (4) Bonding step (see FIG. 2(c))

In the bonding step, the plurality of drawn and tensioned conductive wires are pressed against and bonded to the conductive adhesive that has been applied on the back face electrode layer.

In other words, the five conductive wires 21a that have been drawn in the bus bar disposing step are pressed against and bonded to the conductive adhesive 18 (18a) that has been applied on the back face electrode layer 14.

To describe it more specifically, the five drawn conductive wires 21a are lowered (or the solar cell string 10 is raised toward the conductive wires 21a) and thereby the conductive wires 21a are pressed against the conductive adhesive 18 on the back face electrode layer 14 (see FIG. 2(c)). In this case, as described above, the conductive adhesive 18 (18a) has been applied at a thickness of approximately 30 µm, and the conductive wires 21a have a thickness (diameter) of approximately 60 to 120 µm. Because the thickness of the conductive wires 21a is sufficiently greater than the applied thickness of the conductive adhesive 18 (18a), even when the conductive adhesive applied portions 18 (18a) are pressed from above the conductive wires 21a by a pressing apparatus, the head of the pressing apparatus will not come into direct contact with the conductive adhesive 18 (18a). Accordingly, a cushioning material conventionally used in the press-bonded portion of a pressing apparatus is not needed, producing the advantage of reduction in equipment cost.

Then, in this state, temporary bonding is performed by application of heat at a relatively low temperature that does not completely cure the conductive adhesive 18. In the case where, for example, the conductive adhesive 18 contains a thermosetting resin and metal particles, temporary bonding can be carried out by application of heat at a temperature that is lower than the curing temperature of the thermosetting resin by approximately 70 to 100°C.

When the conductive wires 21a are temporality bonded to the back face electrode layer 14 via the conductive adhesive 18 by being pressed against the back face electrode layer 14 in the manner described above, the conductive adhesive 18 also fills the gaps between adjacent conductive wires 21a (see FIG. 1(b)). In other words, the conductive adhesive 18 is bonded to have an arc-shaped cross section and surround the conductive wires 21a, and thus a bonding structure less subject to damage even when stress is applied can be obtained.

Thereafter, permanent bonding is performed by application of heat at a temperature that cures the conductive adhesive 18. For example, in the case where the conductive adhesive 18 contains a thermosetting resin and metal particles, permanent bonding is carried out by application of heat at a temperature greater than or equal to the curing temperature of the thermosetting resin (for example, 170 to 180°C), whereby a bus bar 21 1 composed of the conductive wires 21a can be bonded onto the back face electrode layer 14.

### (5) Wiring and laminating step (see FIGS. 2(d), and FIGS. 5 and 6)

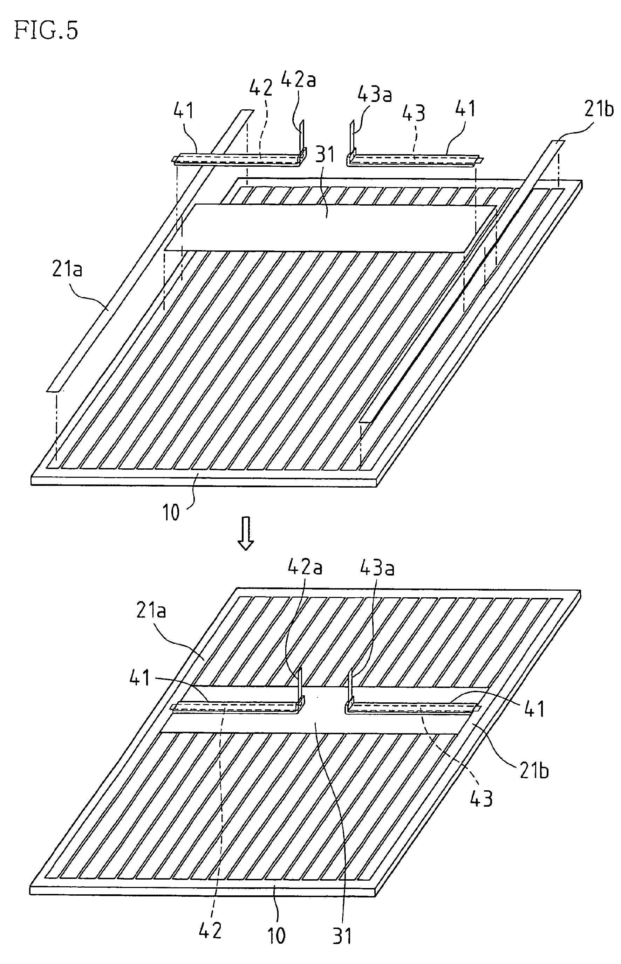

Next, an EVA sheet 31 for bonding is disposed on the solar cell string 10 having the above configuration. On the EVA sheet 31, a positive electrode lead wire 42 and a negative electrode lead wire 43 that are made of flat cables and covered with an insulating film 41 are disposed in line (or parallel, i.e., disposed offset in the width direction), with their tips opposing each other. Then, one end of the positive electrode lead wire 42 is connected to a center position of a bus bar (positive electrode current collecting portion) 21a, and the other end is positioned substantially the center of the solar cell string 10 and bent at a predetermined angle (perpendicularly in FIG. 5) with respect to the face of the solar cell string 10 to serve as a power lead portion 42a. Likewise, one end of the negative electrode lead wire 43 is connected to a center position of another bus bar (negative electrode current collecting portion) 21b, and the other end is positioned substantially the center of the solar cell string 10 and bent at a predetermined angle (perpendicularly in FIG. 5) with respect to the face of the solar cell string 10 to serve as a power lead portion 43a.

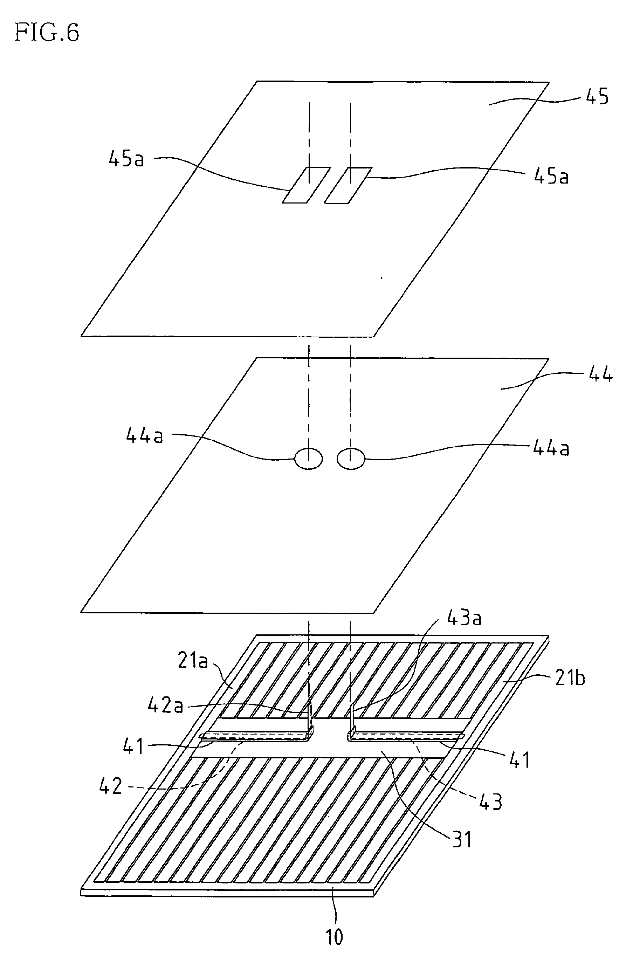

In this state, as shown in FIG. 6, a sealing insulating film 44 and a back film 45 serving as a back face protective sheet for weather resistance and high insulation are disposed, with the power lead portions 42a and 43a of the positive electrode lead wire 42 and the negative electrode lead wire 43 passing through openings 44a and 45a. Through a laminating step and a curing step performed in this state, the back film 45 is laminated and sealed on the entire face of the solar cell string 10, and thereby a thin film solar cell (see FIG. 2(d)) is obtained.

### [Example 2]

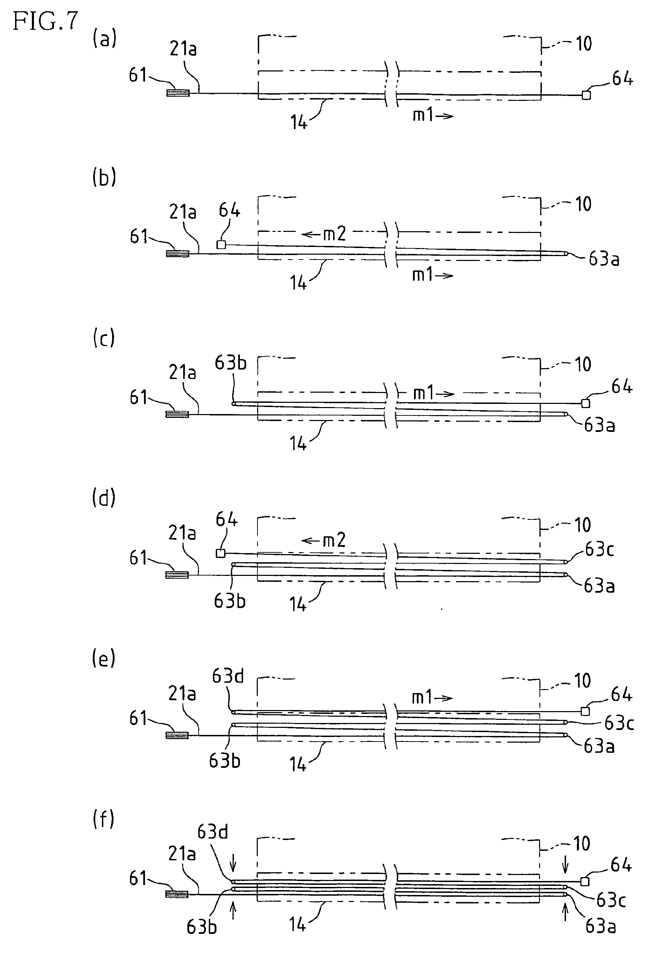

Next, a method of manufacturing a thin film solar cell having the above-described configuration according to Example 2 will be described in several steps including a solar cell string forming step, an adhesive application step, a bus bar disposing step, a bonding step, and a wiring and laminating step. The solar cell string forming step, the adhesive application step and the wiring and laminating step are the same as those of Example 1 described above, and thus descriptions thereof are omitted here, and only the bus bar disposing step and the bonding step will be described with reference to FIGS. 7.

### (1) Bus bar disposing step (see- FIGS. 7)

In the bus bar disposing step, a single conductive wire wound on a reel is drawn with application of tension from one end of the back face electrode layer in one direction along the longitudinal direction to the other end of the back face electrode layer, and then folded back at the other end and drawn in another direction along the longitudinal direction to the one end of the back face electrode layer, again folded back at the one end and drawn in the one direction along the longitudinal direction. The above operations are sequentially repeated.

Specifically, on each back face electrode layer 14 that has the conductive adhesives 18a applied thereto, five conductive wires 21a are disposed side by side in the direction perpendicular to the longitudinal direction of the back face electrode layer 14.

As a method of disposing five conductive wires 21a side by side, for example, as shown in FIGS. 7, a single reel 61 having a conductive wire 21a wound thereon is provided at one end (the left end in FIGS. 7) of the back face electrode layer 14 of the solar cell string 10 placed on a stage (not shown). The tip of the conductive wire 21a pulled from the reel 61 is held by a chuck member 64, and the conductive wire 21a is drawn, with application of tension, in a direction m1 to the other end (the right end in FIGS. 7) of the back face electrode layer 14 (see FIG. 7(a)).

Next, the conductive wire 21a is folded back at a first pin 63a provided at the other end, and drawn in another direction m2 along the longitudinal direction to the one end of the back face electrode layer 14 (see FIG. 7(b)).

Next, the conductive wire 21a is again folded back at a second pin 63b provided at the one end, and drawn in the direction m1 along the longitudinal direction to the other end of the back face electrode layer 14 (see FIG. 7(c)).

Next, the conductive wire 21a is folded back at a third pin 63c provided at the other end, and drawn in the other direction m2 along the longitudinal direction to the one end of the back face electrode layer 14 (see FIG. 7(d)).

Next, the conductive wire 21a is again folded back at a fourth pin 63d provided at the one end, and drawn in the direction m1 along the longitudinal direction to the other end of the back face electrode layer 14 (see FIG. 7(e)).

In this manner, by drawing a single conductive wire 21a in a zigzag pattern, five conductive wires 21a can be disposed in parallel at the same tension.

Thereafter, the pins 63a to 63d are moved and gathered in the direction perpendicular to the longitudinal direction of the back face electrode layer, whereby as shown in FIG. 7(f), the conductive wires 21a can be disposed at specified intervals. The direction in which the pins are gathered is indicated by arrows in FIG. 7(f).

In FIGS. 7, the distance in which tension is applied to the conductive wires 21a by the pins 63a to 63d extends from the right outer end to the left outer end of the solar cell string 10, but the length in which tension is applied may extend within a range of the lengthwise direction of the back face electrode layer 14. Waste of material during cutting can thereby be minimized.

### (2) Bonding step

In the bonding step, the single conductive wire that was drawn in a zigzag pattern in the bus bar disposing step and is under tension is pressed against and bonded to the conductive adhesive that has been applied on the back face electrode layer.

Specifically, the five conductive wires 21a drawn in the bus bar disposing step are pressed against and bonded to the conductive adhesive 18 (18a) that has been applied to the back face electrode layer 14. To describe it more specifically, the five drawn conductive wires 21a are lowered (or the solar cell string 10 is raised toward the conductive wires 21a) and thereby the conductive wires 21a are pressed against the conductive adhesive 18 on the back face electrode layer 14. Then, in this state, temporary bonding is performed by application of heat at a relatively low temperature that does not completely cure the conductive adhesive 18. For example, in the case where the conductive adhesive 18 contains a thermosetting resin and metal particles, temporary bonding can be carried out by application of heat at a temperature that is lower than the curing temperature of the thermosetting resin by approximately 70 to 100°C.

When the conductive wires 21a are temporality bonded to the back face electrode layer 14 via the conductive adhesive 18 by being pressed against the back face electrode layer 14 in the manner described above, the conductive adhesive 18 also fills the gaps between adjacent conductive wires 21a. In other words, the conductive adhesive 18 is bonded to have an arc-shaped cross section so as to surround the conductive wires 21a, and thus a bonding structure less subject to damage even when stress is applied can be obtained.

Thereafter, permanent bonding is performed by application of heat at a temperature that cures the conductive adhesive 18. For example, in the case where the conductive adhesive 18 contains a thermosetting resin and metal particles, permanent bonding is carried out by application of heat at a temperature greater than or equal to the curing temperature of the thermosetting resin (for example, 170 to 180°C), whereby a bus bar 21 composed of the conductive wires 21a can be bonded onto the back face electrode layer 14.

The bus bar disposing step of Example 2 described above employs a configuration in which a single conductive wire 21a wound on a single reel 61 is continuously drawn in a zigzag pattern by folding it back a required number of times, and thereby apparently a plurality of conductive wires 21a are disposed on the back face electrode layer 14. In other words, by drawing a single conductive wire 21a in a repeated pattern, a plurality of conductive wires 21a that are to be disposed on the back face electrode layer 14 can be pulled at a uniform tension, and therefore the conductive wires 21a can be linearly drawn with high accuracy (uniformly). Also, because only a single reel 61 is used, the mechanism for drawing the conductive wire 21a can be simplified and made compact, and the manufacturing cost can be reduced correspondingly.

In the present embodiment, the conductive adhesive 18 is used as the member for bonding the bus bar 21 onto the back face electrode layer 14, but in the case where a conductive tape or anisotropically conductive tape is used, in the bonding step described above, when heat is applied while the conductive wires 21a are pressed against the conductive adhesive 18 on the back face electrode layer 14, it is preferable to apply heat while applying pressure. It is thereby possible to more reliably bond the conductive wires 21a onto the back face electrode layer via the conductive tape.

The present invention may be embodied in various other forms without departing from the gist or essential characteristics thereof. Therefore, the embodiments described above are to be considered in all respects as illustrative and not limiting. The scope of the invention is indicated by the appended claims rather than by the foregoing description. Furthermore, all variations and modifications within a scope equivalent to the scope of the claims are encompassed in the scope of the present invention.

This application claims priority on Japanese Patent Application No. 2009-020314 filed in Japan on January 30, 2009, the content of which is incorporated herein by reference. All of the documents cited in this specification are hereby specifically incorporated in the present application by reference.

### Industrial Applicability

The present invention is useful in that it provides a solar cell module having excellent adhesion with which a bus bar is bonded to a back face electrode layer of a solar cell element, and improved energy conversion efficiency of the solar cell module and bonding strength of the bus bar that are achieved by devising the shape of the bus bar, and a method of manufacturing such a solar cell module.

### Description of Reference Numerals

- 10: Solar Cell String
- 11: Light-Transmitting Insulating Substrate
- 12: Transparent Conductive Film (First Electrode Layer)
- 13: Photoelectric Conversion Layer
- 14: Back Face Electrode Layer (Second Electrode Layer)
- 15, 17: Split Line
- 16: Contact Line
- 18 (18a): Conductive Adhesive Material (Conductive Adhesive)
- 21: Bus Bar
- 21a: Conductive Wire
- 31: EVA Sheet
- 41: Insulating Film
- 42: Positive Electrode Lead Wire
- 42a, 43a: Power Lead Portion
- 43: Negative Electrode Lead Wire
- 44: Sealing Insulating Film
- 44a, 45a: Opening
- 45: Back Film (Back Face Protective Sheet)
- 51,61: Reel
- 52, 53: Drawing Direction Regulating Pin (or Regulating Roller)
- 54, 64: Chuck Member
- 55: Dispensing Mechanism
- 63a: First Pin
- 63b: Second Pin
- 63c: Third Pin
- 63d: Fourth Pin

## Claims

1. A solar cell module having a configuration in which in a solar cell element including a first electrode layer, a photoelectric conversion layer and a second electrode layer formed on a substrate, a bus bar is bonded on the first electrode layer or the second electrode layer with a conductive adhesive material,
wherein the bus bar has a portion in which a plurality of conductive wires are disposed side by side in a direction perpendicular to a longitudinal direction of the first electrode layer or the second electrode layer.

2. The solar cell module according to claim 1,
wherein the plurality of conductive wires are disposed to be spaced apart from each other in the direction perpendicular to the longitudinal direction of the first electrode layer or the second electrode layer.

3. A manufacturing method of a solar cell module comprising the steps of: in a solar cell element including a first electrode layer, a photoelectric conversion layer and a second electrode layer formed on a substrate, disposing a bus bar on the first electrode layer or the second electrode layer; and bonding the bus bar to the first electrode layer or the second electrode layer with a conductive adhesive material,
wherein the bus bar is formed with a plurality of conductive wires disposed side by side in a direction perpendicular to a longitudinal direction of the first electrode layer or the second electrode layer, and
the disposing step includes a step of drawing, with application of tension, the plurality of conductive wires wound on reels along the longitudinal direction of the first electrode layer or the second electrode layer at specified intervals, so as to dispose the plurality of conductive wires side by side in the direction perpendicular to the longitudinal direction.

4. A manufacturing method of a solar cell module comprising the steps of: in a solar cell element including a first electrode layer, a photoelectric conversion layer and a second electrode layer formed on a substrate, disposing a bus bar on the first electrode layer or the second electrode layer; and bonding the bus bar to the first electrode layer or the second electrode layer with a conductive adhesive material,
wherein the bus bar is formed with a plurality of conductive wires disposed side by side in a direction perpendicular to a longitudinal direction of the first electrode layer or the second electrode layer, and
the disposing step includes a step of sequentially repeating operations of drawing, with application of tension, a single conductive wire wound on a reel from one end of the back face electrode layer in one direction along the longitudinal direction to another end of the back face electrode layer, then folding back the conductive wire at the other end and drawing the conductive wire in another direction along the longitudinal direction to the one end of the back face electrode layer, and again folding back the conductive wire at the one end and drawing the conductive wire in the one direction along the longitudinal direction, so as to dispose the plurality of conductive wires side by side in the direction perpendicular to the longitudinal direction.
